# FASCICULE DE BREVET EUROPEEN

(11) **EP 0 290 794 B1**
(45) Date de publication et mention de la délivrance du brevet: **17.03.1993**
(21) Numéro de dépôt: 88105716.0
(22) Date de dépôt: 11.04.1988
(51) Int. Cl.: H03B 5/18

(54) **Oscillateur hyperfréquence à résonateur diélectrique, notamment dans la gamme des 22 GHz**
Hyperfrequenz-Oszillator mit dielektrischem Resonator, insbesondere für den 22 GHz-Bereich
Microwave oscillator with a dielectric resonator, especially for the 22 GHz range

(30) Priorité: 15.04.1987 FR 8705360
(43) Date de publication de la demande: 17.11.1988
(73) Titulaire: ALCATEL TELSPACE, 92734 Nanterre Cédex (FR)
(72) Inventeur: Mettoudi, Isaac, F-92300 Levallois Perret (FR); Lafranca, François, F-77500 Chelles (FR)
(74) Mandataire: Weinmiller, Jürgen

(56) Documents cités:
- EP-A- 0 013 174
- EP-A- 0 121 824
- US-A- 4 618 836
- US-A- 4 628 283

## Description

La présente invention concerne un oscillateur hyperfréquence à résonateur diélectrique, notamment dans la gamme des 22 GHz (de 18 à 24 GHz par exemple).

La nouvelle génération des faisceaux hertziens et des relais mobiles opérant notamment dans la gamme des 22 GHz nécessite de plus en plus l'utilisation de sources de haute stabilité, de faible consommation et de faible coût. Un moyen employé à cet effet consiste à utiliser un oscillateur comportant un composant à l'état solide tel qu'un transistor F.E.T (Field Effect Transistor) AsGa, stabilisé grâce à un résonateur diélectrique.

Un oscillateur de ce type est décrit dans le document US 4 357582. Ce document décrit un oscillateur hyperfréquence comprenant un transistor effet de champ disposé sur un substrat plan. Une première ligne de transmission, disposée sur le substrat, est connectée à la grille du transistor et est terminée par une impédance d'adaptation. Une seconde ligne de transmission est connectée au drain du transistor et est disposée sur le substrat selon un angle prédéterminé par rapport à la première ligne, une troisième ligne étant connectée à la source du transistor et disposée sur le substrat pour fournir la sortie d'oscillation. Un résonateur diélectrique est disposé dans l'angle formé entre la première et la seconde ligne de transmission.

Dans ce document, le moyen utilisé pour ajuster la fréquence de l'oscillateur, consiste à déplacer un disque juste au-dessus du résonateur diélectrique.

Ce moyen bien que pratique, présente cependant, l'inconvénient de perturber les lignes de champ au niveau du résonateur diélectrique. Cela se traduit par une diminution du coefficient de surtension Q en charge.

En effet celui-ci passe alors de 1000 à 500, par exemple suivant la position du disque au-dessus du résonateur diélectrique. Cela se traduit également par une diminution de la stabilité de fréquence ainsi que de la pureté spectrale.

On connaît également par le document US 4 618 836 un oscillateur hyperfréquence du même type, dans lequel le résonateur diélectrique, au lieu d'être disposé sur le substrat, est suspendu au-dessus du substrat au moyen d'une cheminée fileté, ce qui permet d'ajuster la distance entre le substrat et la diélectrique. D'autre part, à l'intérieur de ladite cheminée, un plongeur mobile dont la position selon l'axe de la cheminée peut être réglée en agissant sur une vis filetée, permet d'ajuster la distance entre un disque métallique et le résonateur diélectrique et ainsi de régler la fréquence d'oscillation.
L'un des buts de cette configuration est la compensation des dérivés en fréquence occasionnées par des variations de température du dispositif, notamment celles provenant de la dissipation thermique du (des) composant(s) actif(s) sur le substrat. Cette compensation serait obtenu en jouant sur la dilatation différentielle de certaines pièces, pour faire en sorte que des dilatations mécaniques se produisent avec des amplitudes sensiblement les mêmes, mais en sens inverse, lors des excursions en température. Un tel système présente de nombreux inconvénients, tant en ce qui concerne sa conception que sa réalisation et une éventuelle mise en oeuvre, qui tiennent au nombre des pièces à assembler, avec une très grande précision de réalisation des pièces et leur disposition relative, ainsi que l'ajustage nécessaire pour obtenir le fonctionnement souhaité.

L'invention à pour objet de pallier ces inconvénients.

Elle propose, à cet effet, un oscillateur hyperfréquence à résonateur diélectrique, comprenant un tel résonateur diélectrique et un élément à résistance négative disposé à la surface d'un substrat, situés à l'intérieur d'un boîtier métallique, qui est muni d'un dégagement situé au-dessus d'un résonateur diélectrique, disposé sur le substrat, de manière à ne perturber que très faiblement les lignes de champ dues à ce résonateur, ce dégagement étant une cheminée, de direction perpendiculaire à la surface du substrat munie d'un filetage, dans lequel est disposé au moins une vis de fermeture destinée à permettre un réglage de la fréquence dudit oscillateur;
caractérisé en ce que pour travailler notamment dans la gamme des 22 GHz, le substrat est formé de deux plaquettes, à la surface supérieure desquelles sont disposées des lignes microruban, le résonateur diélectrique étant disposé à la surface supérieure de l'une d'elles, la surface inférieure des plaquettes étant soudée sur la masse du boîtier de part et d'autre de l'élément à résistance négative qui est un transistor soudé sur un support bon conducteur thermique lui-même soudé sur la masse même du boîtier; le drain de ce transistor étant relié à une première piste microruban dite de drain, la grille étant reliée à une seconde ligne microruban dite de grille, la polarisation de grille et la polarisation de drain s'effectuant par l'intermédiaire de lignes basse impédance en quart de cercle et de lignes forte impédance la piste de grille étant terminée à son extrémité sur une charge 50 Ω, un gap permettant d'isoler la grille de cette charge 50 Ω, un gap se trouvant également sur la piste de drain pour isoler le drain de la charge connectée en sortie.

Avantageusement dans un tel oscillateur les lignes de champ dues au résonateur diélectriques ne sont que très faiblement perturbées.

Dans une réalisation avantageuse le dégagement est une cheminée de direction perpendiculaire du substrat, munie d'un filetage, dans laquelle est disposée au moins une vis de fermeture présentant un double filetage, à l'intérieur de laquelle se trouve une vis auto-serrante et ajustable, qui vient se visser dans la cheminée, la vis à double filetage étant fixée sur la cheminée à l'aide d'un écrou de blocage, le boîtier étant muni d'un couvercle dans lequel est usiné le dégagement.

Plus particulièrement l'oscillateur se compose du boîtier sur lequel viennent se souder deux plaquettes de part et d'autre d'un transistor FET monté sur un support lui-même soudé sur la masse même du boîtier. Le drain de ce transistor est relié à une première piste microruban de "drain". La grille est reliée à une seconde ligne microruban, les polarisations de grille et de drain s'effectuant par l'intermédiaire de lignes basse impédance en quart de cercle et de lignes forte impédance. La piste de grille est terminée à son extrémité par une charge 50 Ω, un "gap" permettant d'isoler la grille de cette charge. Un "gap" se trouve également sur la piste de drain pour isoler ce drain de la charge connectée en sortie.

Avantageusement le boîtier est en laiton, le substrat est en quartz, le support du transistor est en cuivre, les vis sont en bronze-béryllium.

De telles caractéristiques de l'oscillateur de l'invention permettent d'obtenir une meilleure stabilité de fréquence en fonction de la température et une plus grande pureté spectrale.

Les caractéristiques et avantages de l'invention ressortiront d'ailleurs de la description qui va suivre, à titre d'exemple non limitatif, en référence aux figures annexées sur lesquelles :
- la figure 1 est une vue en coupe de l'oscillateur selon l'invention ;
- la figure 2 est une vue de dessus d'une partie de l'oscillateur représenté à la figure 1.

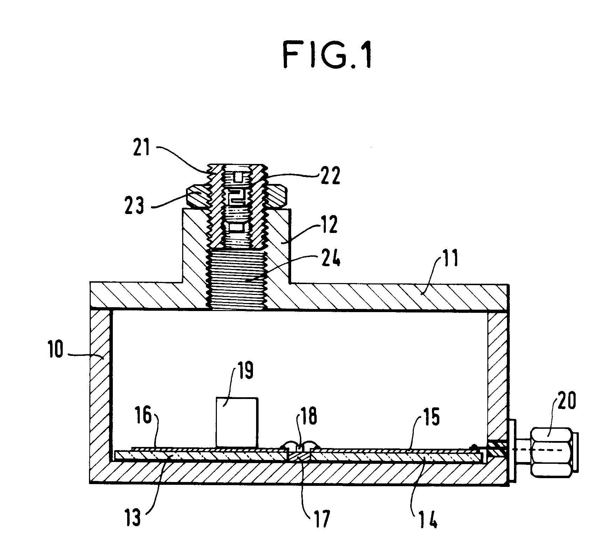

Comme représenté à la figure 1, l'oscillateur selon l'invention comprend :
- un boîtier 10 de forme parallélépidédique coiffé d'un couvercle 11 muni d'une cheminée 12 ;
- un substrat disposé à l'intérieur de ce boîtier, formé de deux parties 13 et 14, à la surface duquel sont disposées des lignes microruban 15, 16 et un résonateur diélectrique 19,
- un petit support 17 soudé à la masse du boîtier, disposé entre les deux parties 13 et 14 du substrat, et sur lequel est soudé un transistor 18,
- une fiche de sortie 20 fixée au boîtier.

La cheminée 12 prévue dans le couvercle du boîtier est disposée au dessus du résonateur 19. De ce fait, les lignes de champ dues à ce résonateur ne sont que très faiblement perturbées. Un ajustement en fréquence est rendu possible à l'aide d'une double vis (21, 22) associée à un écrou de blocage 23.

Cette cheminée 12 est usinée directement dans le couvercle 11 du boîtier 10 de l'oscillateur. L'ouverture centrale 24 de cette cheminée 12 se trouve au-dessus du résonateur diélectrique 19. L'intérieur de cette cheminée comporte un filetage. A l'intérieur de cette cheminée vient se visser une vis creuse 21 présentant un double filetage. Cette vis 21 à double filetage est fixée sur la cheminée 12 à l'aide de l'écrou de blocage 23.

A l'intérieur de cette double vis 21 se trouve une vis 22 auto-serrante et ajustable.

L'ouverture 24 de la cheminée 22 permet un dégagement pour les lignes de champ au niveau du résonateur diélectrique 19.

Un premier réglage de la fréquence de l'oscillateur est obtenu au moyen de la vis 21 creuse à double filetage. Un réglage fin est obtenu grâce à la vis auto-serrante 22.

Dans tous les cas de réglage un talon de quelques millimètres doit être prévu entre le bord intérieur du couvercle 11 et l'extrémité de la vis 21 à double filetage comme représenté à la figure 1.

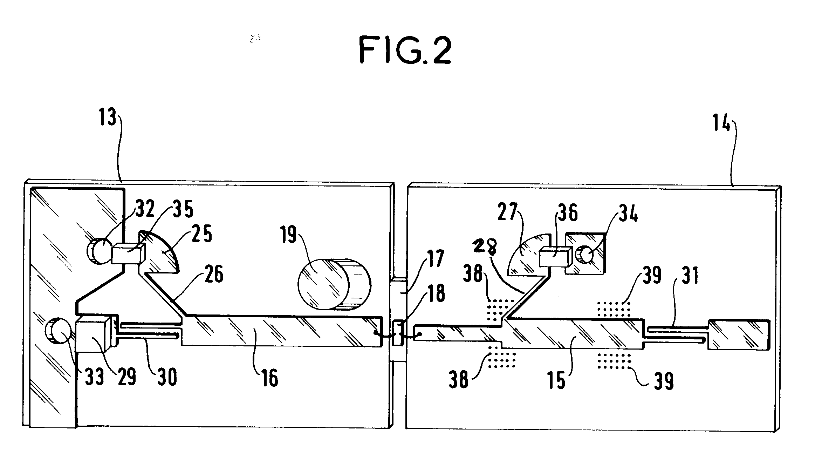

Dans un exemple de réalisation l'oscillateur 22 GHz à résonateur diélectrique de l'invention se compose du boîtier 10, en laiton par exemple, sur lequel on vient souder les deux plaquettes 13, 14, en quartz par exemple, de part et d'autre du transistor 18. Ce transistor FET As Ga, en puce, est monté sur le support 17, en cuivre par exemple, qui est lui-même soudé sur la masse même du boîtier 10 afin d'assurer une bonne dissipation thermique pour le transistor. Le drain de ce transistor 18 est relié, comme représenté à la figure 2, à une première piste microruban 15 "de drain". La grille est reliée à une seconde ligne microruban 16 "de grille". La polarisation de grill s'effectue par l'intermédiaire d'une ligne basse impédance 25 en quart de cercle et d'une ligne forte impédance 26 qui rend l'influence du circuit de polarisation négligeable aux fréquences de travail. La polarisation de drain s'effectue par l'intermédiaire d'une ligne basse impédance 27 en quart de cercle et d'une ligne forte impédance 28.

La piste de grille 16 est terminée à son extrémité par une charge 50Ω(29). Un "gap" 30 (filtre passe bande centré à la fréquence de 22 GHz avec une bande passante minimale de 2,4 GHz par exemple) permet d'isoler la grille du transistor de la charge 50Ω(29).

Un "gap" 31 se trouve également sur la piste de drain 15 pour isoler le drain du transistor de la charge connectée en sortie, non représentée sur la figure 2.

Le résonateur diélectrique 19 couplé à la piste microruban 16 reliée à la grille du transistor permet de déterminer la fréquence de sortie de l'oscillateur.

Sur le boîtier se trouve le couvercle 11, en laiton par exemple. Dans ce couvercle est usiné un trou taraudé qui constitue la cheminée 12. Dans ce trou taraudé vient se visser la vis 21 à double filetage, en bronze-beryllium par exemple. A l'intérieur de cette vis 21 à double filetage vient se visser la vis 22 auto-serrante et ajustable, en bronze-beryllium par exemple. Le dispositif à cheminée constitue donc un moyen pratique de régler la fréquence de sortie de l'oscillateur et permet un dégagement des lignes de champ au dessus du résonateur diélectrique 19.

Sur le substrat, représenté à la figure 2, apparaissent également des trous métallisés 32, 33 et 34, qui permettant une liaison avec un plan de masse situé de l'autre côté du substrat, et deux capacités de découplage 35 et 36.

Les lignes basses impédances 25 et 27 sont reliées à des fiches, non représentées sur les figures permettant d'entrer respectivement les signaux de polarisation de grille et de drain.

Les zones 38 et 39, pour lesquelles un dépôt, de laque d'argent par exemple, a été effectué à la surface du substrat de part et d'autre de la ligne 15 permettant de réaliser des stubs d'accord, ont été représentée pour illustrer un moyen de réglage d'impédance en deux points de la ligne 15.

L'oscillateur selon l'invention permet de conserver un coefficient de surtension Q élevé lors du réglage de la fréquence de l'oscillateur. Cela se traduit par une meilleure stabilité de fréquence en fonction de la température et une plus grande pureté spectrale de l'oscillateur.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

Ainsi de dégagement réalisé par la cheminée 12 peut être légèrement décalé par rapport au résonateur diélectrieur, de quelques dixièmes de millimètres par exemple.

Ainsi le transistor FET peut être remplacé par un autre élément à résistance négative tel qu'une diode GUNN par exemple.

## Revendications

1. Oscillateur hyperfréquence à résonateur diélectrique, comprenant un tel résonateur diélectrique (19) et un élément à résistance négative (18) disposé à la surface d'un substrat (13, 14), situés à l'intérieur d'un boîtier (10) métallique, qui est muni d'un dégagement (12) situé au-dessus d'un résonateur diélectrique (19), disposé sur le substrat (13, 14), de manière à ne perturber que très faiblement les lignes de champ dues à ce résonateur, ce dégagement (12) étant une cheminée, de direction perpendiculaire à la surface du substrat (13, 14) munie d'un filetage, dans lequel est disposé au moins une vis de fermeture destinée à permettre un réglage de la fréquence dudit oscillateur;
caractérisé en ce que pour travailler notamment dans la gamme des 22 GHz, le substrat est formé de deux plaquettes (13, 14), à la surface supérieure desquelles sont disposées des lignes microruban (15, 16), le résonateur diélectrique (19) étant disposé à la surface supérieure de l'une d'elles, la surface inférieure des plaquettes étant soudée sur la masse du boîtier (10) de part et d'autre de l'élément à résistance négative qui est un transistor (18) soudé sur un support bon conducteur thermique (17) lui-même soudé sur la masse même du boîtier (10); le drain de ce transistor (18) étant relié à une première piste microruban (15) dite de drain, la grille étant reliée à une seconde ligne microruban (16) dite de grille, la polarisation de grille et la polarisation de drain s'effectuant par l'intermédiaire de lignes basse impédance (25, 27) en quart de cercle et de lignes forte impédance (26, 28) la piste de grille (16) étant terminée à son extrémité sur une charge 50 Ω (29), un gap (30) permettant d'isoler la grille de cette charge 50 Ω (29), un gap (31) se trouvant également sur la piste de drain (15) pour isoler le drain de la charge connectée en sortie.

2. Oscillateur selon la revendication 1, caractérisé en ce qu'une vis creuse (21) présentant un double filetage, à l'intérieur de laquelle se trouve une vis (22) auto-serrante et ajustable, vient se visser dans la cheminée (12).

3. Oscillateur selon la revendication 2, caractérisé en ce que la vis (21) à double filetage est fixée sur la cheminée à l'aide d'un écrou de blocage (23).

4. Oscillateur selon l'une quelconque des revendications précédentes, caractérisé en ce que le boîtier est muni d'un couvercle (11) dans lequel est usiné le dégagement.

5. Oscillateur selon l'une quelconque des revendications précédentes, caractérisé en ce que l'élément à résistance négative est un transistor FET (18).

6. Oscillateur selon l'une quelconque des revendications précédentes, caractérisé en ce que le boîtier (10) est en laiton.

7. Oscillateur selon l'une quelconque des revendications précédentes, caractérisé en ce que le substrat (13, 14) est en quartz.

8. Oscillateur selon l'une quelconque des revendications 5 à 7, caractérisé en ce que le support (17) du transistor (18) est en cuivre.

9. Oscillateur selon l'une quelconque des revendications précédentes, caractérisé en ce que les vis (21, 12) sont en bronze-beryllium.

10. Oscillateur selon l'une quelconque des revendications précédentes, caractérisé en ce que des zones (38, 39) de dépôt d'argent sont réalisées de part et d'autre de la ligne (15) de drain, en au moins un endroit.

## Claims

1. A microwave oscillator having a dielectric resonator, which comprises such a dielectric resonator (19) and a negative resistance (18) disposed on the surface of a substrate (13, 14) situated inside a metallic housing (10), which is provided with a clearance (12) situated over a dielectric resonator (19) disposed on the substrate (13, 14), such that the field lines due to the dielectric resonator are only very slightly disturbed, said clearance (12) being a chimney extending perpendicularly to the surface of the substrate (13, 14) and provided with threads in which at least one closure screw is disposed, in order to adjust the frequency of said oscillator;
characterized in that in view of an operation notably in the 22 GHz range, the substrate is made up of two small plates (13, 14), on the upper surface of which are disposed microstriplines (15, 16), the dielectric resonator (19) being disposed on the upper surface of one of them, with the lower surface of the plates being welded to the ground of the housing (10) on both sides of the negative resistance element, which is a transistor (18) welded onto a support (17) having an effective thermal conductivity and being itself welded onto the proper ground of the housing (10); the drain of the transistor (18) being connected to a first microstrip track (15) or drain stripline, the grid being connected to a second microstrip track (16) or grid stripline, the biasing of the drain being obtained via low impedance lines (25, 27) forming quarter circle sections and via high impedance lines (26, 28), with the grid stripline (16) being matched at its end by a 50-ohm load (29), a gap (30) permitting to isolate the grid from said 50-ohm load (29), and a gap (31) being also provided in the drain stripline (15) for isolating the drain from the load connected to its output.

2. An oscillator according to claim 1, characterized in that a hollow screw (21) having two threads and bearing an adjustable self-locking screw (22), is screwed into the chimney (12).

3. An oscillator according to claim 2, characterized in that the double-threaded screw (21) is fixed to the chimney by means of a lock nut (23).

4. An oscillator according to any preceding claim, characterized in that the housing is provided with a lid (11) having the clearance machined therein.

5. An oscillator according to any preceding claim, characterized in that the negative resistance component is a field effect transistor (18).

6. An oscillator according to any preceding claim, characterized in that the housing (10) is made of brass.

7. An oscillator according to any preceding claim, characterized in that the substrate (13, 14) is made of quartz.

8. An oscillator according to any one of claims 5 to 7, characterized in that the support (17) for the transistor (18) is made of copper.

9. An oscillator according to any preceding claim, characterized in that the screws (21, 22) are made of beryllium bronze.

10. An oscillator according to any preceding claim, characterized in that zones of silver deposit (38, 39) are provided on either side of the drain stripline (15), at least at one location.

## Patentansprüche

1. Mikrowellenoszillator mit dielektrischem Resonator, der einen solchen dielektrischen Resonator (19) und ein Element mit negativem Widerstand (18) aufweist, das auf der Oberfläche eines Substrats (13, 14) im Inneren eines metallischen Gehäuses (10) angeordnet ist, das mit einem Freiraum (12) oberhalb eines auf dem Substrat (13, 14) angeordneten dielektrischen Resonators (19) versehen ist, derart, daß die durch den Resonator bedingten Feldlinien nur sehr wenig gestört werden, wobei der Freiraum ein senkrecht zur Oberfläche des Substrats (13, 14) verlaufender Schacht mit einem Gewinde ist, in dem mindestens eine Verschlußschraube angebracht ist, die die Justierung der Frequenz des Oszillators ermöglicht,
dadurch gekennzeichnet, daß das Substrat für den Betrieb vor allem im Bereich um 22 Ghz aus zwei Plättchen (13, 14) besteht, auf deren Oberseite Mikrostreifenleitungen (15, 16) angebracht sind, wobei der dielektrische Resonator (19) auf der Oberseite eines der Plättchen angeordnet ist, während die Unterseite der Plättchen zu beiden Seiten des Elementes mit negativem Widerstand an die Masse des Gehäuses (10) angelötet ist, wobei dieser Widerstand ein auf einem gut wärmeleitenden Träger (17) aufgelöteter Transistor (18) ist und der Träger seinerseits an der Masse des Gehäuses (10) angelötet ist, während der Drain dieses Transistors (18) mit einer ersten Mikrostreifenbahn (15), Drainbahn genannt, verbunden ist und das Gate mit einer zweiten Mikrostreifenbahn (16), Gatebahn genannt, verbunden ist, wobei das Vorspannen des Gates und das Vorspannen des Drains über Leitungen geringer Impedanz (25, 27) in Form von Viertelkreissektoren und über Leitungen hoher Impedanz (26, 28) bewirkt wird und die Gatebahn (16) an ihrem Ende mit einer Last (29) von 50 Ω abgeschlossen ist, wobei ein Spalt (30) die Trennung des Gates von der Last (29) von 50 Ω ermöglicht, während sich ein weiterer Spalt (31) in der Drainbahn (15) befindet, um den Drain von der an den Ausgang angeschlossenen Last zu trennen.

2. Oszillator nach Anspruch 1, dadurch gekennzeichnet, daß eine hohle Schraube (21) mit doppeltem Gewinde, in deren Innerem sich eine selbsthemmende und justierbare Schraube (22) befindet, in den Schacht (12) eingeschraubt ist.

3. Oszillator nach Anspruch 2, dadurch gekennzeichnet, daß die Schraube (21) mit doppeltem Gewinde im Schacht mit Hilfe einer Blockiermutter (23) befestigt ist.

4. Oszillator nach einem beliebigen der vorhergehenden Ansprüche, dadurch gekennzeichnet, daß das Gehäuse mit einem Deckel (11) versehen ist, in den der Freiraum eingearbeitet ist.

5. Oszillator nach einem beliebigen der vorhergehenden Ansprüche, dadurch gekennzeichnet, daß das Element mit negativem Widerstand ein Feldeffekttransistor (18) ist.

6. Oszillator nach einem beliebigen der vorhergehenden Ansprüche, dadurch gekennzeichnet, daß das Gehäuse (10) aus Messing besteht.

7. Oszillator nach einem beliebigen der vorhergehenden Ansprüche, dadurch gekennzeichnet, daß das Substrat (13, 14) aus Quarz besteht.

8. Oszillator nach einem beliebigen der Ansprüche 5 bis 7, dadurch gekennzeichnet, daß der Träger (17) des Transistors (18) aus Kupfer besteht.

9. Oszillator nach einem beliebigen der vorhergehenden Ansprüche, dadurch gekennzeichnet, daß die Schrauben (21, 12) aus Berylliumbronze bestehen.

10. Oszillator nach einem beliebigen der vorhergehenden Ansprüche, dadurch gekennzeichnet, daß mit Silber bedeckte Zonen (38, 39) zu beiden Seiten der Drainleitung (15), zumindest an einer Stelle, angebracht sind.
